# EUROPEAN PATENT SPECIFICATION

(11) **EP 3 835 939 B1**
(45) Date of publication and mention of the grant of the patent: **14.02.2024**
(21) Application number: 20188067.1
(22) Date of filing: 28.07.2020
(51) Int. Cl.: G06F 7/483, G06F 7/499

(54) **ERROR-BOUND FLOATING POINT DATA COMPRESSION SYSTEM**
FEHLERGEBUNDENES GLEITKOMMADATENKOMPRESSIONSSYSTEM
SYSTÈME DE COMPRESSION DE DONNÉES À VIRGULE FLOTTANTE À ERREUR LIMITÉE

(30) Priority: 09.12.2019 US 201916707582
(43) Date of publication of application: 16.06.2021
(73) Proprietor: SAP SE, 69190 Walldorf (DE)
(72) Inventor: RUPP, Martin, 69190 Walldorf (DE)
(74) Representative: Müller-Boré & Partner Patentanwälte PartG mbB

(56) References cited:
- WO-A1-2018/099788
- US-A1- 2017 185 398
- US-A1- 2019 095 303

## Description

### BACKGROUND

Modern computing deployments generate tremendous amounts of data. Storage of this data consumes significant computing resources. Data compression techniques may be used to reduce the amount of stored data, and to therfore also reduce the resources required to store the data.

Data compression may be lossless, in which the original data can be reproduced exactly from compressed data, or lossy, in which exact reproduction of the original data from compressed data is not guaranteed. Lossy compression typically exhibits higher compression rates and/or faster processing than lossless compression. The compression technique to apply in a particular scenario depends on the error tolerance of the scenario as well on the type of data to be compressed.

Systems such as Internet-of Things (IoT) architectures may produce floating point data. For example, an IoT sensor may provide temperature data which, after transformation from Celsius to Farenheit, is represented as a 64-bit double precision value. Compression of this data prior to storage is therefore desired. Moreover, due to the known accuracy limitations of the IoT sensor, it may be permissible to store these values such that decompression will result in a maximum error bound of 0.01 per value.

For example, it will be assumed that the values {1.241, 1.240, 1.239, 1.241, 1.253} are to be stored in view of an error bound of 0.01. According to a known approach for lossy floating point compression, the first four values are recognized as being within the error bound of a same value (i.e., 1.24) and the values are therefore stored as {4x 1.24, 1x 1.253} (e.g., as "run" array {4, 1} and "value" array {1.24, 1.253}). However, if consecutive values vary significantly with respect to the error bound (e.g., {1.2348903, 3.489345, -21.2344903, ...}, the known approach stores the data as {1x 1.2348903, 1x 3.489345, 1x -21.2344903, ...} (e.g., as "run" array {1, 1, 1, ...} and "value" array {1.2348903, 3.489345, -21.2344903, ...}), which fails to provide satisfactory compression.

Improvements to error-bound floating point compression are desired.

US 2019/095303 A1 describes systems and methods evaluating simulation models and measuring floating point arithmetic errors in terms of Unit in Last Place (ULP). The simulation model may include model elements that perform numerical computations using Native Floating Point (NFP) arithmetic. The model elements may be arranged to implement a procedure. A data store may include local ULP errors predetermined for the model elements. The systems and methods may retrieve the local ULP errors for the model elements included in the model, and may apply a rules-based analysis to compute an overall ULP error of the simulation model. The systems and methods may present the overall ULP computed for the model. The systems and methods may also present intermediate ULP errors determined for portions of the simulation model. Changes may be made to the model to reduce the overall ULP error.

The underlying technical problem is solved by the subject-matter according to the independent claims. Specific embodiments are defined in the dependent claims.

### BRIEF DESCRIPTION OF THE DRAWINGS

FIG. 1 illustrates an architecture for generating, compressing, storing and retrieving floating point values according to some embodiments.
FIG. 2 is a tabular representation of floating point sensor values according to some embodiments.
FIG. 3 is a tabular representation of double precision versions of the FIG. 2 sensor values according to some embodiments.
FIG. 4 is a flow diagram of a process to round floating point values based on an error bound according to some embodiments.
FIG. 5 is a tabular representation of rounded versions of the FIG. 2 sensor values according to some embodiments.
FIG. 6 illustrates a processing pipeline for compressing floating point values according to some embodiments.
FIG. 7 illustrates a processing pipeline for compressing floating point values according to some embodiments.
FIG. 8 illustrates a processing pipeline for compressing floating point values according to some embodiments.
FIG. 9 is a flow diagram of a process to round floating point values based on an error bound and a total sum of values according to some embodiments.
FIG. 10 is a flow diagram of a process to round floating point values based on an error bound and a total sum of values according to some embodiments.
FIG. 11 is a block diagram of a computing system according to some embodiments.

### DETAILED DESCRIPTION

The following description is provided to enable any person in the art to make and use the described embodiments and sets forth the best mode contemplated for carrying out some embodiments. Various modifications, however, will be readily-apparent to those in the art.

Embodiments relate to rounding each of a plurality of floating point values to a particular number of decimal places. Each of the rounded values is within a specified error-bound of its original value. The rounded values may then be subjected to further floating point compression, which in turn may include integer compression according to some embodiments. Some embodiments further operate to reduce or eliminate a difference in a sum total of error-bounded rounded values with respect to a sum total of corresponding original floating point values.

Some embodiments may therefore provide improved error-bound compression of input floating point values which exhibit, with respect to the error bound, a significant number of decimal places and/or large variances in consecutive values.

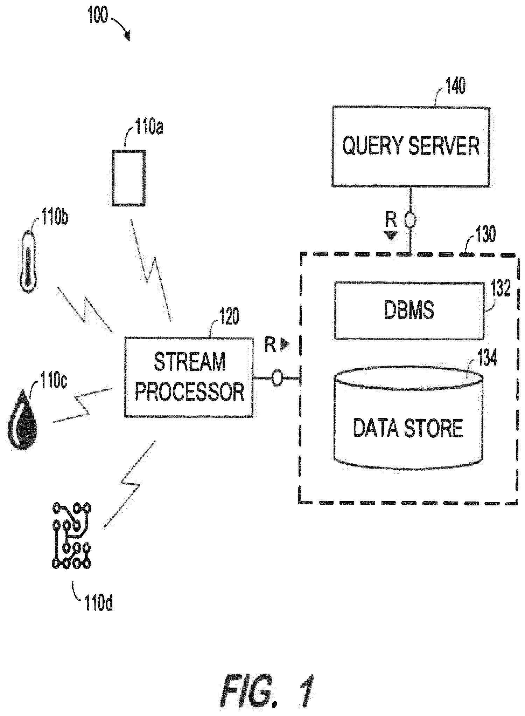

FIG. 1 illustrates architecture 100 according to some embodiments. Architecture 100 includes sensors 110a-110d, each of which provides floating point values to stream processor 120. Sensors 110a-110d may comprise any types and/or number of sensors, and may provide data to stream processor 120 on request, asynchronously, and/or according to any schedule or criteria. Stream processor 120 may comprise a processing component (e.g., an IoT hub) capable of receiving IoT data and processing it as desired. Embodiments are not limited to floating point values generated by sensors or processed by a stream processor.

According to the illustrated example, stream processor 120 transmits received floating point values to database platform 130 for storage. Stream processor 120 may compress the data as described herein prior to transmission to database platform.

Database platform 130 comprises database management system (DBMS) 132 and data store 134. DBMS 132 may operate to compress data as described herein prior to storage in data store 134 and decompress thusly-stored data prior to providing the data to a requestor. DBMS 132 may also perform administrative and management functions for database platform 130. Such functions may include snapshot and backup management, indexing, optimization, garbage collection, and/or any other database functions that are or become known.

Data store 134 may comprise any storage system for storing data in any format that is or becomes known. Data store 134 may include data of database tables and metadata describing the structure of the data, but embodiments are not limited thereto. The data of data store 134 may comprise one or more of conventional tabular data, row-based data, column-based data, and object-based data. Moreover, the data may be indexed and/or selectively replicated in an index to allow fast searching and retrieval thereof.

Database platform 130 may implement an "in-memory" database, in which a full database stored in volatile (e.g., non-disk-based) memory (e.g., Random Access Memory). The full database may be persisted in and/or backed up to fixed disks (not shown). Embodiments are not limited to an in-memory implementation. For example, data may be stored in Random Access Memory (e.g., cache memory for storing recently-used data) and one or more fixed disks (e.g., persistent memory for storing their respective portions of the full database).

Query server 140 may process Structured Query Language (SQL) and MultiDimensional expression (MDX) statements received from a database application (not shown). Processing may include generation of and execution of a query execution plan to retrieve data from data store 134. As described above, DBMS 132 may decompress retrieved data prior to transmitting the data to query server 140.

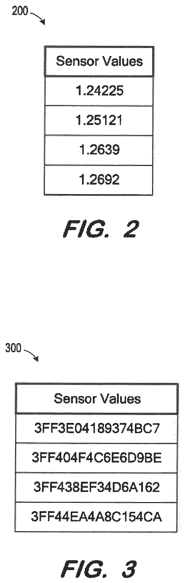

FIG. 2 is a tabular representation of floating point sensor values 200 which may be compressed according to some embodiments. Sensor values 200 may be received from any suitable source or sources, and embodiments are not limited to values generated by sensors. For purposes of comparison, FIG. 3 is a tabular representation of double precision values 300 corresponding to sensor values 200 according to some embodiments. Embodiments may attempt to compress values such as sensor values 200 to a storage space of less than 64-bits per value, while maintaining a specified error bound.

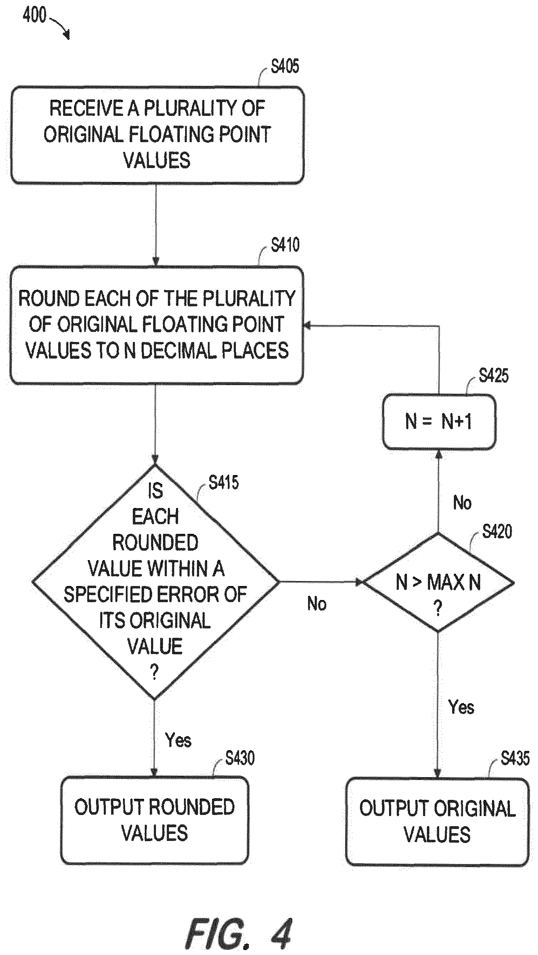

FIG. 4 is a flow diagram of process 400 to round floating point values based on an error bound according to some embodiments. In some non-exhaustive embodiments, various hardware elements of a database system execute program code to perform process 400. Process 400 and all other processes mentioned herein may be embodied in processor-executable program code read from one or more of non-transitory computer-readable media, such as a hard disk drive, a volatile or non-volatile random-access memory, a DVD-ROM, a Flash drive, and a magnetic tape, and then stored in a compressed, uncompiled and/or encrypted format. In some embodiments, hard-wired circuitry may be used in place of, or in combination with, program code for implementation of processes according to some embodiments. Embodiments are not limited to any specific combination of hardware and software.

Initially, a plurality of original floating point values are received at S405. The plurality of floating point values may be received or acquired from any source that is or becomes known. Each of the plurality of original floating point values may comprise a positive or a negative value and each of the plurality of original floating point values may include any number of decimal places.

According to some embodiments, also received at S405 is an indication of an error bound, or quantization error. The error bound may indicate a maximum per-value error which may be exhibited by the values resulting from process 400. Accordingly, S405 may comprise reception of a command to compress a set of floating point values in view of a particular error bound.

In some embodiments, the component executing process 400 is aware of an applicable error bound. For example, in the case of architecture 100, DBMS 132 may receive a command at S405 to store a plurality of floating point values. DBMS 132 then independently determines to execute the remainder of process 400 to compress and store the floating point values in view of a predetermined error bound.

At S410, each of the plurality of original floating point values is rounded to a particular number (i.e., N) of decimal places. According to the presently-described example, N is initially set to a small number. Embodiments are not limited thereto, and these alternative embodiments will be described below.

More specifically, it will be assumed that the plurality of original floating point values are sensor values 200 of FIG. 2, the error bound is 0.01, and N is initially set to zero. At 5410, each of sensor values 200 is rounded to value having zero decimal places. Accordingly, {1.24225, 1.25121, 1.2639, 1.2692} is rounded to {1, 1, 1, 1}. This rounding may be performed using a "scaling factor" according to some embodiments, such that rounded_value = round(original_ value*scaling_factor)/scaling factor. Using an initial scaling factor of 1 (which corresponds to N = 0) at S410, rounded_value= round(1.24225*1)/1= 1.

Next, at S415, it is determined whether each rounded value is within a specified error of its corresponding original value. Mathematically, for each original value, S415 evaluates whether |original_ value - rounded_value| < 0.01 is TRUE. With reference to the present example, S415 determines whether |1.24225-1| < 0.01, 11.25121-11 < 0.01, |1.2639 - 1| < 0.01, |1.2692 - 1| < 0.01 are all TRUE. In other embodiments, S415 may include determination of a maximum (original_ value - rounded_value) and comparison of the maximum against the error bound. Int either case, and since none of the above inequalities are TRUE, the determination at S415 in the above example is negative.

Flow proceeds to S420 if the determination at S415 is negative. At S420, it is determined whether N has reached a maximum prespecified value. S420 provides an exit from process 400 in a case that the number of decimal points required to meet the error bound is greater than desired, or if one or more original values are such that the error bound cannot be met regardless of the number of decimal places to which the values are rounded (e.g., Inf). Accordingly, flow proceeds to S435 to simply output the original floating point values if the determination at S420 is positive.

If N has not yet reached the maximum prespecified value, flow proceeds from S420 to S425 to increment N. Each of the plurality of original floating point values is then rounded to the incremented number of decimal places at S410.

Assuming N is now equal to 1, the rounding may be performed at S410 using a scaling factor of 10. For example, rounded_ value= round(1.24225*10)/10= 1.2, rounded_ value= round(1.25121*10)/10= 1.3, rounded_ value= round(1.2639*10)/10= 1.3, and rounded_ value= round(1.2692*10)/10= 1.3. Corresponding errors of each rounded value are {0.04225, 0.04879, 0.0361, 0.0308}. Since all of these values are greater than 0.01, the subsequent determination at S415 is negative and flow returns to S420.

N is incremented at S425 to 2, corresponding to a scaling factor of 100. Accordingly, at S410, rounded_ value= round(1.24225*100)/100= 1.24, rounded_ value= round(1.25121*100)/100= 1.25, rounded_ value=round(1.2639*100)/100= 1.26, and rounded_ value= round(1.2692*100)1100= 1.27. Corresponding errors of each rounded value are {0.00225, 0.00121, 0.0039, 0.0008}. It is therefore determined at S415 that each rounded value is within 0.01 of its original value.

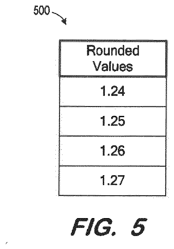

Flow proceeds from S415 to S430 to output the rounded values. With reference to the above example, the output values are {1.24, 1.25, 1.26, 1.27}. FIG. 5 is a tabular representation of output rounded values 500 according to some embodiments.

As mentioned above, some embodiments of S410 utilize a larger initial value (e.g., 20) for N. A positive determination at S415 therefore causes N to be decremented and rounding to occur at S410 based on the decremented value. Flow continues in this manner until the determination at S415 is negative, in which case the output rounded values are those corresponding to the prior value of N (and corresponding scaling factor).

The output rounded floating point values may then be subjected to further compression. Use of the output rounded floating point values rather than the original floating point values may result in higher compression ratios than other lossy floating point compression techniques.

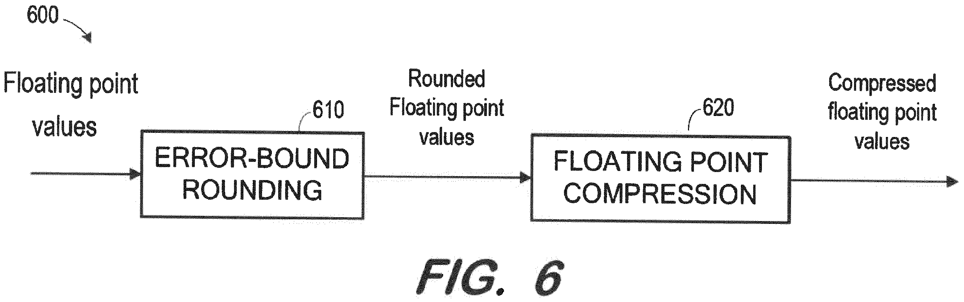

FIGS. 6 through 8 illustrate processing pipelines for compressing floating point values according to some embodiments. The illustrated pipelines may be implemented in any system in which floating point value compression is desired. Embodiments are not limited to the illustrated pipelines.

Pipeline 600 includes error-bound rounding component 610 to receive floating point values. Component 610 may execute process 400 upon the received floating point values to generate and output rounded floating point values as described above. Component 610 may also receive an error bound value for use in process 400. Component 610 and each other component of FIGS. 6 through 8 may comprise one or more processing units executing program code.

Floating point compression component 620 receives the rounded floating point values from rounding component 610 and performs compression to generate and output compressed floating point values. The compressed floating point values may be stored and/or transmitted as desired. Floating point compression component 620 may perform any type of floating point compression, lossless or lossy, that is or becomes known.

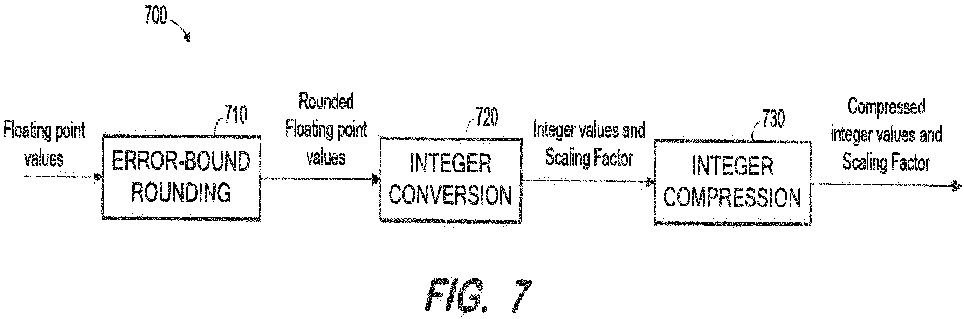

Pipeline 700 of FIG. 7 may comprise a specific implementation of pipeline 600 according to some embodiments. Error-bound rounding component 710 may execute process 400 as described above. Integer conversion component 720 and integer compression component 730 may together perform floating point compression. For example, integer conversion component 720 may convert the rounded values output by rounding component 710 to integer values. Since the rounded values may each exhibit a same number of decimal places N, integer conversion component 720 may determine a scaling factor 10^{N} which is then multiplied by each rounded value to generate a plurality of integer values.

The plurality of integer values and scaling factor are received by integer compression component 730. Component 730 may compress the integer values using any integer compression algorithm that is or becomes known. The algorithm may comprise a combination of algorithms such as, but not limited to, but compression, run-length compression and delta compression. As is known, the combination may be dependent on the specific integer values being compressed and/or their relationship to one another.

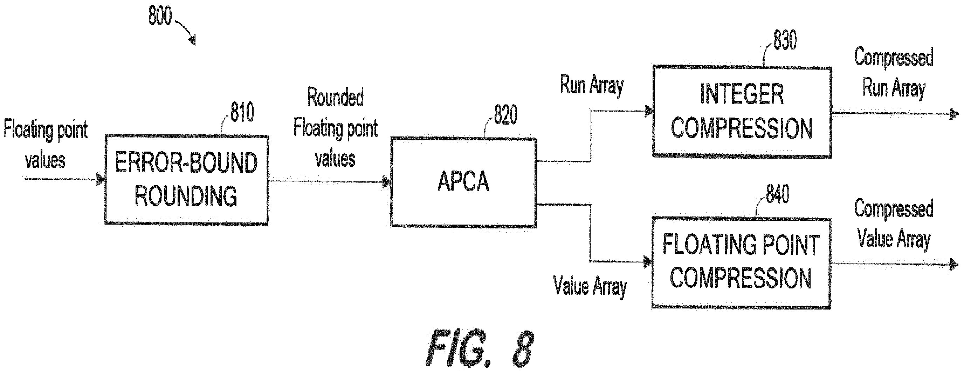

FIG. 8 illustrates pipeline 800 including error-bound rounding component 810, which may execute process 400 to generate a plurality of rounded floating point values. The rounded floating point values may be subjected to adaptive piecewise approximation by component 820 as described in the above Background. For example, if the rounded values output by component 810 are {1.241, 1.240, 1.239, 1.241, 1.253} and are to be lossy-compressed by component 820 with an error bound of 0.01, the values are output as "run" array {4, 1} and "value" array {1.24, 1.253}). The run array may then be subjected to integer compression by integer compression component 830 to generate a compressed run array, and the value array may be subjected to floating point compression by floating point compression component 840 to generate a compressed value array. The floating point compression of component 840 may proceed as described above with respect to components 720 and 730, but embodiments are not limited thereto.

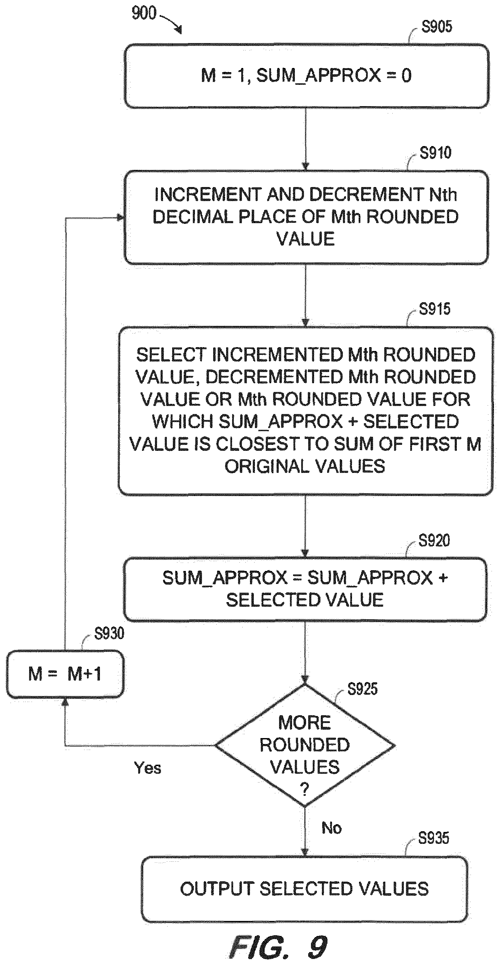

FIG. 9 a flow diagram of process 900 to round floating point values based on an error bound and a total sum of values according to some embodiments. Process 900 may be executed on the rounded values output by process 400 in some scenarios. For example, any of components 610, 710 and 810 described above may execute process 400 followed by process 900 to compress a plurality of floating point values based on an error bound and also on a total sum of the compressed values.

To illustrate the relevance of the total sum of values, consider the following plurality of values to be compressed: {1.24, 1.24, 1.24, 1.24, 1.24, 1.24, 1.24, 1.24, 1.24, 1.24}. The average value is 1.24 and the sum of the values is 12.4. Using process 400 to compress the values in view of an error bound of 0.1, the resulting rounded values would be {1.2, 1.2, 1.2, 1.2, 1.2, 1.2, 1.2, 1.2, 1.2, 1.2}, which have an average value of 1.2 and a total sum of 12. Accordingly, if the rounded values were stored in place of the original values, certain aggregate calculations on the stored data would result in different solutions than had they been performed on the original data.

The following rounded values are also within the error bound of 0.1 of the original values: {1.2, 1.2, 1.2, 1.2, 1.2, 1.2, 1.3, 1.3, 1.3, 1.3}. The average of these values is 1.24 and the sum is 12.4, as was the case with the original values. Accordingly, the second set of rounded values may be considered a closer representation of the original values in some scenarios. For example, certain aggregate calculations on the second set of rounded values may result in solutions more similar to those which would have been generated if the calculations were applied to the original values.

It will be assumed that, prior to process 900, a plurality of original floating point values has been compressed to a plurality of rounded floating point values having N decimal places, for example by process 400. Process 900 begins at S905, at which the values M and sum_approx are initialized to 1 and 0, respectively.

Next, at S910, the Nth decimal place of the Mth (i.e., first) rounded value is incremented to generate an incremented rounded value and decremented to generate a decremented rounded value. For example, assuming N = 2 and the first rounded value is 1.23, the first incremented value is 1.24 and the first decremented value is 1.22.

At S915, one of the first rounded value, the first incremented value, and the first decremented value is selected. The selected value is the value which is within the error bound of the Mth original value and for which sum_approx + the selected value is closest to the sum of the first M original floating point values. In the case of the first iteration of S915, the selected value is simply the value which is within the error bound and closest to the first original value. Returning to the above example, if the original value was 1.2349 and the error bound is 0.01, then the first incremented value of 1.24 is within the error bound and the first decremented value of 1.22 is not. The difference between the first incremented value (1.24) and the original value (1.2349) is .0051, and the difference between the first rounded value (1.23) and the original value (1.2349) is .0049. Accordingly, the first rounded value (1.23) is selected at S915.

The selected value is added to sum_approx to generate a new running sum of the selected values. S925 determines whether a next rounded value of the plurality of rounded values exists. If so, M is incremented by 1 at S930 and flow returns to S910 to increment the Nth decimal place of the Mth (i.e., second) rounded value to generate a second incremented rounded value and decrement the Nth decimal place of the Mth (i.e., second) rounded value to generate a second decremented rounded value.

S915 proceeds as described above with respect to the second rounded, incremented and decremented values. One of these values is selected which is within the error bound of the second original value (the second rounded value will be within the error bound by virtue of process 400) and for which the new sum_approx + the selected value is closest to the sum of the first two original floating point values. Flow then proceeds to S920 as described above.

Accordingly, flow cycles from S910 through S930 until it is determined at S925 that the last rounded value of the plurality of rounded values has been processed. Next, at S935, each of the M values selected during the M iterations of S915 is output. As described above, the output values will be within an error bound of their corresponding original values, and a sum of the original values may be closer to a sum of the output values than to a sum of the rounded values input to process 900.

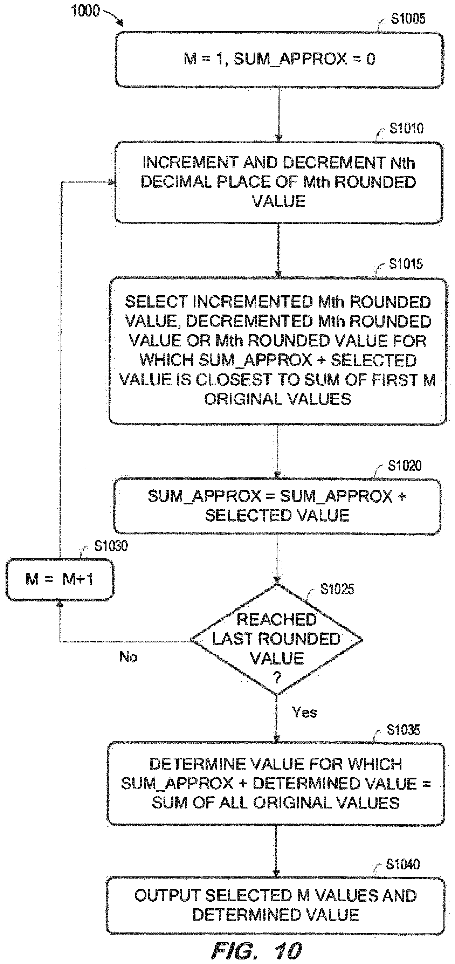

FIG. 10 is a flow diagram of process 1000 to round floating point values based on an error bound and a total sum of values according to some embodiments. Unlike process 900, the sum of the output values of process 1000 is intended to be equal to a sum of the original plurality of non-rounded floating point values.

For a given plurality of rounded input values V, process 1000 selects the same values at S1015 as selected at S915 of process 900 for the first through V-1 values. However, upon determining at S1025 that a last rounded value V remains to be processed, flow continues to S1035. At S1035, a value is determined for which the sum of all selected values will be equal to the sum of the plurality of original floating point values. In other words, the determined value is the differences between the sum of the plurality of original floating point values and the then-current sum_approx. The selected M values and the value determined at S1035 are output at S1040.

The value determined at S1035 may comprise any number of decimal places and may be stored as a different type (e.g., double-precision) and subjected to different compression than the output selected M values. In a case that process 400 + 1000 is run on blocks of 10,000 input values, one such correction value is stored for every 10,000 entries.

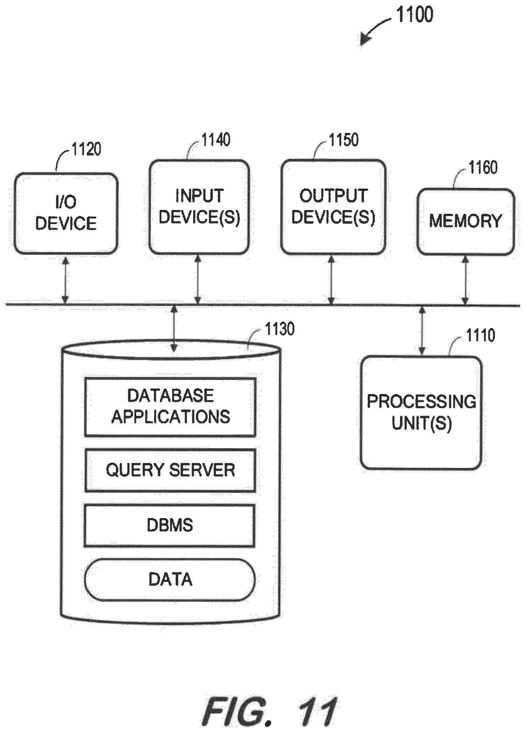

FIG. 11 is a block diagram of database system 1100 according to some embodiments. Database system 1100 may comprise a general-purpose computing apparatus and may execute program code to perform any of the functions described herein. Database system 1100 may comprise an implementation of database platform 130 in some embodiments. Database system 1100 may include other unshown elements according to some embodiments.

Database system 1100 includes processing unit(s) 1110 operatively coupled to I/O device 1120, data storage device 1130, one or more input devices 1140, one or more output devices 1150 and memory 1160. I/O device 1120 may facilitate communication with external devices, such as a streaming hub, a client device, or a data storage device. Input device(s) 1140 may comprise, for example, a keyboard, a keypad, a mouse or other pointing device, a microphone, knob or a switch, an infra-red (IR) port, a docking station, and/or a touch screen. Input device(s) 1140 may be used, for example, to enter information into system 1100. Output device(s) 1150 may comprise, for example, a display (e.g., a display screen) a speaker, and/or a printer.

Data storage device 1130 may comprise any appropriate persistent storage device, including combinations of magnetic storage devices (e.g., magnetic tape, hard disk drives and flash memory), optical storage devices, Read Only Memory (ROM) devices, etc., while memory 1160 may comprise Random Access Memory (RAM).

The database applications, query server and database management system of data storage device may each comprise program code executed by processing unit(s) 1110 to cause system 1100 to perform any one or more of the processes described herein. Embodiments are not limited to execution of these processes by a single computing device.

Data stored in device 1130 may include database tables as is known. Database tables (either cached or a full database) may be stored in volatile memory such as volatile memory 1160. Data storage device 1130 may also store data and other program code for providing additional functionality and/or which are necessary for operation of system 1100, such as device drivers, operating system files, etc.

The foregoing diagrams represent logical architectures for describing processes according to some embodiments, and actual implementations may include more or different components arranged in other manners. Other topologies may be used in conjunction with other embodiments. Moreover, each component or device described herein may be implemented by any number of devices in communication via any number of other public and/or private networks. Two or more of such computing devices may be located remote from one another and may communicate with one another via any known manner of network(s) and/or a dedicated connection. Each component or device may comprise any number of hardware and/or software elements suitable to provide the functions described herein as well as any other functions. For example, any computing device used in an implementation some embodiments may include a processor to execute program code such that the computing device operates as described herein.

Embodiments described herein are solely for the purpose of illustration. Those in the art will recognize other embodiments may be practiced with modifications and alterations to that described above.

## Claims

1. A system (1100) comprising:
a memory storing processor-executable program code; and
a processing unit (1110) to execute the processor-executable program code in order to cause the system (1100) to:
receive (S405) a plurality of original floating point values (200);
round (S410, S415) each of the plurality of original floating point values (200) to a respective rounded floating point value (500), where each rounded floating point value (500) is within a prespecified error bound of its respective original floating point value (200); and
compress the plurality of rounded floating point values (500),
wherein rounding (S410, S415) of each of the plurality of original floating point values (200) to a respective rounded floating point value (500) comprises:
rounding of each of the plurality of original floating point values (200) to a respective first rounded floating point value having a first number of decimal places;
determination of whether each first rounded floating point value is within the prespecified error bound of its respective original floating point value;
if it is determined that each first rounded floating point value is not within the prespecified error bound of its respective original floating point value,
incrementing the first number of decimal places to generate a second number of decimal places,
rounding of each of the plurality of original floating point values (200) to a respective second rounded floating point value having the second number of decimal places, and
determination of whether each second rounded floating point value is within the prespecified error bound of its respective original floating point value (200);
if it is determined that each first rounded floating point value is within the prespecified error bound of its respective original floating point value,
outputting (S430) each first rounded floating point value as the plurality of rounded floating point values (500); and
if it is determined that each second rounded floating point value is within the prespecified error bound of its respective original floating point value,
outputting (S430) each second rounded floating point value as the plurality of rounded floating point values (500).

2. The system according to Claim 1, wherein compression of the plurality of rounded floating point values (500) comprises:
conversion of each of the plurality of rounded floating point values (500) to an integer value; and
performance of integer compression on the plurality of integer values, and/or
performance of adaptive piecewise compression on the plurality of rounded floating point values (500).

3. The system according to any one of Claims 1 or 2, the processing unit (1110) to execute the processor-executable program code in order to cause the system (1100) to:
modify one or more of the plurality of rounded floating point values (500) based on a sum of the plurality of original floating point values (200), where each of the modified one or more of the plurality of rounded floating point values (500) is within the prespecified error bound of its respective original floating point value, and/or,
modify one of the plurality of rounded floating point values (500) so that a sum of the plurality of original floating point values (200) is equal to a sum of the modified one or more of the plurality of rounded floating point values (500), the modified one of the plurality of rounded floating point values (500) and any unmodified ones of the plurality of rounded floating point values (500).

4. The system according to Claim 3, wherein a number of bits of the modified one of the plurality of rounded floating point values (500) is greater than a number of bits of each of the modified one or more of the plurality of rounded floating point values (500) and any unmodified ones of the plurality of rounded floating point values (500).

5. The system (1100) according to any one of Claims 1 to 4, further comprising:
a database server; and
a data storage system,
wherein the database server is to:
receive an instruction to store the plurality of original floating point values (200) within an error bound;
in response to the instruction, round each of the plurality of original floating point values (200) to a respective rounded floating point value, where each rounded floating point value is within the error bound of its respective original floating point value;
compress the plurality of rounded floating point values (500); and
store the plurality of compressed rounded floating point values in the data storage system (134).

6. A computer-implemented method (400), comprising:
receiving (S405) a plurality of original floating point values (200);
receiving (S405) an error bound;
rounding (S410, S415) each of the plurality of original floating point values (200) to a respective rounded floating point value (500), where each rounded floating point value (500) is within the error bound of its respective original floating point value (200); and
storing the plurality of rounded floating point values (500) in a compressed format,
wherein rounding (S410, S415) of each of the plurality of original floating point values (200) to a respective rounded floating point value (500) comprises:
rounding each of the plurality of original floating point values (200) to a respective first rounded floating point value having a first number of decimal places;
determining whether each first rounded floating point value is within the error bound of its respective original floating point value;
if it is determined that each first rounded floating point value is not within the error bound of its respective original floating point value,
incrementing the first number of decimal places to generate a second number of decimal places,
rounding each of the plurality of original floating point values (200) to a respective second rounded floating point value having the second number of decimal places, and
determining whether each second rounded floating point value is within the error bound of its respective original floating point value;
if it is determined that each first rounded floating point value is within the error bound of its respective original floating point value,
outputting (S430) each first rounded floating point value as the plurality of rounded floating point values (500); and
if it is determined that each second rounded floating point value is within the error bound of its respective original floating point value,
outputting (S430) each second rounded floating point value as the plurality of rounded floating point values (500).

7. The method according to Claim 6, wherein storing comprises:
converting each of the plurality of rounded floating point values (500) to an integer value; and
performing integer compression on the plurality of integer values, and/or
performing of adaptive piecewise compression on the plurality of rounded floating point values (500).

8. The method according to any one of Claims 6 or 7, further comprising:
modifying one or more of the plurality of rounded floating point values (500) based on a sum of the plurality of original floating point values (200), where each of the modified one or more of the plurality of rounded floating point values (500) is within the prespecified error bound of its respective original floating point value, and/or,
modifying one of the plurality of rounded floating point values (500) so that a sum of the plurality of original floating point values (200) is equal to a sum of the modified one or more of the plurality of rounded floating point values (500), the modified one of the plurality of rounded floating point values (500) and any unmodified ones of the plurality of rounded floating point values (500).

9. The method according to Claim 8, wherein a number of bits of the modified one of the plurality of rounded floating point values (500) is greater than a number of bits of each of the modified one or more of the plurality of rounded floating point values (500) and any unmodified ones of the plurality of rounded floating point values (500).

## Patentansprüche

1. System (1100), aufweisend:
einen Speicher, der von einem Prozessor ausführbaren Programmcode speichert; und
eine Verarbeitungseinheit (1110) zum Ausführen des von einem Prozessor ausführbaren Programmcodes, um zu bewirken, dass das System (1100) Folgendes durchführt:
Empfangen (S405) einer Vielzahl von ursprünglichen Gleitkommawerten (200);
Runden (S410, S415) jedes der Vielzahl von ursprünglichen Gleitkommawerten (200) auf einen jeweiligen gerundeten Gleitkommawert (500), wobei jeder gerundete Gleitkommawert (500) innerhalb einer vorab spezifizierten Fehlergrenze seines jeweiligen ursprünglichen Gleitkommawerts (200) liegt; und
Komprimieren der Vielzahl von gerundeten Gleitkommawerten (500),
wobei das Runden (S410, S415) jedes der Vielzahl von ursprünglichen Gleitkommawerten (200) auf einen jeweiligen gerundeten Gleitkommawert (500) umfasst:
Runden jedes der Vielzahl von ursprünglichen Gleitkommawerten (200) auf einen jeweiligen ersten gerundeten Gleitkommawert mit einer ersten Anzahl von Dezimalstellen;
Bestimmen, ob jeder erste gerundete Gleitkommawert innerhalb der vorab spezifizierten Fehlergrenze seines jeweiligen ursprünglichen Gleitkommawerts liegt;
falls bestimmt wird, dass jeder erste gerundete Gleitkommawert nicht innerhalb der vorab spezifizierten Fehlergrenze seines jeweiligen ursprünglichen Gleitkommawerts liegt,
Inkrementieren der ersten Anzahl von Dezimalstellen, um eine zweite Anzahl von Dezimalstellen zu erzeugen,
Runden jedes der Vielzahl von ursprünglichen Gleitkommawerten (200) auf einen jeweiligen zweiten gerundeten Gleitkommawert mit der zweiten Anzahl von Dezimalstellen, und
Bestimmen, ob jeder zweite gerundete Gleitkommawert innerhalb der vorab spezifizierten Fehlergrenze seines jeweiligen ursprünglichen Gleitkommawerts (200) liegt;
falls bestimmt wird, dass jeder erste gerundete Gleitkommawert innerhalb der vorab spezifizierten Fehlergrenze seines jeweiligen ursprünglichen Gleitkommawerts liegt,
Ausgeben (S430) jedes ersten gerundeten Gleitkommawerts als die Vielzahl von gerundeten Gleitkommawerten (500); und
falls bestimmt wird, dass jeder zweite gerundete Gleitkommawert innerhalb der vorab spezifizierten Fehlergrenze seines jeweiligen ursprünglichen Gleitkommawerts liegt,
Ausgeben (S430) jedes zweiten gerundeten Gleitkommawerts als die Vielzahl von gerundeten Gleitkommawerten (500).

2. System nach Anspruch 1, wobei die Komprimierung der Vielzahl von gerundeten Gleitkommawerten (500) umfasst:
Umwandeln jedes der Vielzahl von gerundeten Gleitkommawerten (500) auf einen ganzzahligen Wert; und
Durchführen einer Ganzzahlkomprimierung auf der Vielzahl von ganzzahligen Werten, und/oder
Durchführen einer adaptiven stückweisen Komprimierung auf der Vielzahl von gerundeten Gleitkommawerten (500).

3. System nach einem der Ansprüche 1 oder 2, wobei die Verarbeitungseinheit (1110) den von einem Prozessor ausführbaren Programmcode ausführt, um zu bewirken, dass das System (1100) Folgendes durchführt:
Modifizieren eines oder mehrerer der Vielzahl von gerundeten Gleitkommawerten (500) basierend auf einer Summe der Vielzahl von ursprünglichen Gleitkommawerten (200), wobei jeder der modifizierten einen oder mehreren der Vielzahl von gerundeten Gleitkommawerten (500) innerhalb der vorab spezifizierten Fehlergrenze seines jeweiligen ursprünglichen Gleitkommawerts liegt, und/oder
Modifizieren eines der Vielzahl von gerundeten Gleitkommawerten (500), so dass eine Summe aus der Vielzahl von ursprünglichen Gleitkommawerten (200) gleich einer Summe aus der modifizierten einen oder mehreren der Vielzahl von gerundeten Gleitkommawerten (500), des modifizierten einen der Vielzahl von gerundeten Gleitkommawerten (500) und jedwedem nicht modifizierten der Vielzahl von gerundeten Gleitkommawerten (500) ist.

4. System nach Anspruch 3, wobei eine Anzahl von Bits des modifizierten einen der Vielzahl von gerundeten Gleitkommawerten (500) größer als eine Anzahl von Bits jedes der modifizierten einen oder mehreren der Vielzahl von gerundeten Gleitkommawerten (500) und jedweden nicht modifizierten der Vielzahl von gerundeten Gleitkommawerten (500) ist.

5. System (1100) nach einem der Ansprüche 1 bis 4, ferner aufweisend:
einen Datenbankserver; und
ein Datenspeichersystem,
wobei der Datenbankserver durchführt:
Empfangen einer Anweisung zum Speichern der Vielzahl von ursprünglichen Gleitkommawerten (200) innerhalb einer Fehlergrenze;
als Reaktion auf die Anweisung, Runden jedes der Vielzahl von ursprünglichen Gleitkommawerten (200) auf einen jeweiligen gerundeten Gleitkommawert, wobei jeder gerundete Gleitkommawert innerhalb der Fehlergrenze seines jeweiligen ursprünglichen Gleitkommawerts liegt;
Komprimieren der Vielzahl von gerundeten Gleitkommawerten (500); und
Speichern der Vielzahl von komprimierten gerundeten Gleitkommawerten in dem Datenspeichersystem (134).

6. Computerimplementiertes Verfahren (400), umfassend:
Empfangen (S405) einer Vielzahl von ursprünglichen Gleitkommawerten (200);
Empfangen (S405) einer Fehlergrenze;
Runden (S410, S415) jedes der Vielzahl von ursprünglichen Gleitkommawerten (200) auf einen jeweiligen gerundeten Gleitkommawert (500), wobei jeder gerundete Gleitkommawert (500) innerhalb der Fehlergrenze seines jeweiligen ursprünglichen Gleitkommawerts (200) liegt; und
Speichern der Vielzahl von gerundeten Gleitkommawerten (500) in einem komprimierten Format,
wobei das Runden (S410, S415) jedes der Vielzahl von ursprünglichen Gleitkommawerten (200) auf einen jeweiligen gerundeten Gleitkommawert (500) umfasst:
Runden jedes der Vielzahl von ursprünglichen Gleitkommawerten (200) auf einen jeweiligen ersten gerundeten Gleitkommawert mit einer ersten Anzahl von Dezimalstellen;
Bestimmen, ob jeder erste gerundete Gleitkommawert innerhalb der Fehlergrenze seines jeweiligen ursprünglichen Gleitkommawerts liegt;
falls bestimmt wird, dass jeder erste gerundete Gleitkommawert nicht innerhalb der Fehlergrenze seines jeweiligen ursprünglichen Gleitkommawerts liegt;
Inkrementieren der ersten Anzahl von Dezimalstellen zum Erzeugen einer zweiten Anzahl von Dezimalstellen,
Runden jedes der Vielzahl von ursprünglichen Gleitkommawerten (200) auf einen jeweiligen zweiten gerundeten Gleitkommawert mit der zweiten Anzahl von Dezimalstellen, und
Bestimmen, ob jeder zweite gerundete Gleitkommawert innerhalb der Fehlergrenze seines jeweiligen ursprünglichen Gleitkommawerts liegt;
falls bestimmt wird, dass jeder erste gerundete Gleitkommawert innerhalb der Fehlergrenze seines jeweiligen ursprünglichen Gleitkommawerts liegt,
Ausgeben (S430) jedes ersten gerundeten Gleitkommawerts als die Vielzahl von gerundeten Gleitkommawerten (500); und
falls bestimmt wird, dass jeder zweite gerundete Gleitkommawert innerhalb der Fehlergrenze seines jeweiligen ursprünglichen Gleitkommawerts liegt,
Ausgeben (S430) jedes zweiten gerundeten Gleitkommawerts als die Vielzahl von gerundeten Gleitkommawerten (500).

7. Verfahren nach Anspruch 6, wobei das Speichern umfasst:
Umwandeln jedes der Vielzahl von gerundeten Gleitkommawerten (500) in einen ganzzahligen Wert; und
Durchführen einer Ganzzahlkomprimierung auf der Vielzahl von ganzzahligen Werten, und/oder
Durchführen einer adaptiven stückweisen Komprimierung auf der Vielzahl von gerundeten Gleitkommawerten (500).

8. Verfahren nach einem der Ansprüche 6 oder 7, ferner umfassend:
Modifizieren eines oder mehrerer der Vielzahl von gerundeten Gleitkommawerten (500) basierend auf einer Summe der Vielzahl von ursprünglichen Gleitkommawerten (200), wobei jeder der modifizierten einen oder mehreren der Vielzahl von gerundeten Gleitkommawerten (500) innerhalb der vorab spezifizierten Fehlergrenze seines jeweiligen ursprünglichen Gleitkommawerts liegt, und/oder
Modifizieren eines der Vielzahl von gerundeten Gleitkommawerten (500), so dass eine Summe aus der Vielzahl von ursprünglichen Gleitkommawerten (200) gleich einer Summe aus der modifizierten einen oder mehreren der Vielzahl von gerundeten Gleitkommawerten (500), des modifizierten einen der Vielzahl von gerundeten Gleitkommawerten (500) und jedweden nicht modifizierten der Vielzahl von gerundeten Gleitkommawerten (500) ist.

9. Verfahren nach Anspruch 8, wobei eine Anzahl von Bits des modifizierten einen der Vielzahl von gerundeten Gleitkommawerten (500) größer als eine Anzahl von Bits jedes der modifizierten einen oder mehreren der Vielzahl von gerundeten Gleitkommawerten (500) und jedweden nicht modifizierten der Vielzahl von gerundeten Gleitkommawerten (500) ist.

## Revendications

1. Système (1100) comprenant :
une mémoire stockant un code de programme pouvant être exécuté par un processeur ; et
une unité de traitement (1110) destinée à exécuter le code de programme pouvant être exécuté par le processeur pour amener le système (1100) à :
recevoir (S405) une pluralité de valeurs à virgule flottante d'origine (200) ;
arrondir (S410, S415) chacune de la pluralité de valeurs à virgule flottante d'origine (200) à une valeur à virgule flottante arrondie (500) respective, où chaque valeur à virgule flottante arrondie (500) se situe dans une limite d'erreur prédéfinie de sa valeur à virgule flottante d'origine (200) respective ; et
comprimer la pluralité de valeurs à virgule flottante arrondies (500) ;
dans lequel l'arrondissement (S410, S451) de chacune de la pluralité de valeurs à virgule flottante d'origine (200) à une valeur à virgule flottante arrondie (500) respective comprend :
l'arrondissement de chacune de la pluralité de valeurs à virgule flottante d'origine (200) à une première valeur à virgule flottante arrondie respective présentant un premier nombre de décimales ;
la détermination de savoir si chaque première valeur à virgule flottante arrondie se situe dans la limite d'erreur prédéfinie de sa valeur à virgule flottante d'origine respective ;
s'il est déterminé que chaque première valeur à virgule flottante d'origine ne se situe pas dans la limite d'erreur prédéfinie de sa valeur à virgule flottante d'origine respective,
- l'incrémentation du premier nombre de décimales pour générer un deuxième nombre de décimales,
- l'arrondissement de chacune de la pluralité de valeurs à virgule flottante d'origine (200) à une deuxième valeur à virgule flottante arrondie respective présentant le deuxième nombre de décimales, et
- la détermination pour savoir si chaque deuxième valeur à virgule flottante arrondie se situe dans la limite d'erreur prédéfinie de sa valeur à virgule flottante d'origine (200) respective ;
s'il est déterminé que chaque première valeur à virgule flottante arrondie se situe dans la limite d'erreur prédéfinie de sa valeur à virgule flottante d'origine respective,
- la délivrance en sortie (S430) de chaque première valeur à virgule flottante arrondie en tant que la pluralité de valeurs à virgule flottante arrondies (500) ; et
s'il est déterminé que chaque deuxième valeur à virgule flottante se situe dans la limite d'erreur prédéfinie de sa valeur à virgule flottante d'origine respective
- la délivrance en sortie (S430) de chaque deuxième valeur à virgule flottante arrondie en tant que la pluralité de valeurs à virgules flottantes arrondies (500).

2. Système selon la revendication 1, dans lequel la compression de la pluralité de valeurs à virgule flottante arrondies (500) comprend :
la conversion de chacune de la pluralité de valeurs à virgule flottante arrondies (500) en une valeur entière ; et
la réalisation d'une compression entière sur la pluralité de valeurs entières, et/ou
la réalisation d'une compression adaptative élément par élément sur la pluralité de valeurs à virgule flottante arrondies (500).

3. Système selon l'une quelconque des revendications 1 ou 2, l'unité de traitement (1110) permettant d'exécuter le code de programme pouvant être exécuté par un processeur pour amener le système (1100) à :
modifier une ou plusieurs de la pluralité de valeurs à virgule flottante arrondies (500) sur la base d'une somme de la pluralité de valeurs à virgule flottante d'origine (200), où chacune des une ou plusieurs valeurs modifiées de la pluralité de valeurs à virgule flottante arrondies (500) est dans la limite d'erreur prédéfinie de sa valeur à virgule flottante d'origine respective, et/ou
modifier une de la pluralité de valeurs à virgule flottante arrondies (500) de telle manière qu'une somme de la pluralité de valeurs à virgule flottante d'origine (200) est égale à une somme des une ou plusieurs valeurs modifiées de la pluralité de valeurs à virgule flottante arrondies (500), de la valeur modifiée de la pluralité de valeurs à virgule flottante arrondies (500) et de toute valeur non modifiée de la pluralité de valeurs à virgule flottante arrondies (500).

4. Système selon la revendication 3, dans lequel un nombre de bits de la valeur modifiée de la pluralité de valeurs à virgule flottante arrondies (500) est supérieur à un nombre de bits de chacune des une ou plusieurs valeurs modifiées de la pluralité de valeurs à virgule flottante arrondies (500) et de toute valeur non modifiée de la pluralité de valeurs à virgule flottante arrondies (500).

5. Système (1100) selon l'une quelconque des revendications 1 à 4, comprenant en outre :
un serveur de base de données ; et
un système de stockage de données,
dans lequel le serveur de base de données est configuré pour :
recevoir une instruction pour stocker la pluralité de valeurs à virgule flottante d'origine (200) dans une limite d'erreur ;
en réponse à l'instruction, arrondir chacune de la pluralité de valeurs à virgule flottante d'origine (200) à une valeur à virgule flottante arrondie respective, où chaque valeur à virgule flottante arrondie se situe dans la limite d'erreur de sa valeur à virgule flottante d'origine respective ;
comprimer la pluralité de valeurs à virgule flottante arrondies (500) ; et
stocker la pluralité de valeurs à virgule flottante arrondies comprimées dans le système de stockage de données (134).

6. Procédé mis en oeuvre par ordinateur (400), comprenant :
la réception (S405) d'une pluralité de valeurs à virgule flottante d'origine (200) ;
la réception (S405) d'une limite d'erreur ;
l'arrondissement (S410, S415) de chacune de la pluralité de valeurs à virgule flottante d'origine (200) à une valeur à virgule flottante arrondie (500) respective, où chaque valeur à virgule flottante arrondie (500) se situe dans la limite d'erreur de sa valeur à virgule flottante d'origine (200) ; et
le stockage de la pluralité de valeurs à virgule flottante arrondies (500) dans un format comprimé,
dans lequel l'arrondissement (S410, S415) de chacune de la pluralité de valeurs à virgule flottante d'origine (200) à une valeur à virgule flottante arrondie (500) respective comprend :
l'arrondissement de chacune de la pluralité de valeurs à virgule flottante d'origine (200) à une première valeur à virgule flottante arrondie respective présentant un premier nombre de décimales ;
la détermination de savoir si chaque première valeur à virgule flottante arrondie se situe dans la limite d'erreur de sa valeur à virgule flottante d'origine respective ;
s'il est déterminé que chaque première valeur à virgule flottante arrondie ne se situe pas dans la limite d'erreur de sa valeur à virgule flottante d'origine,
- l'incrémentation du premier nombre de décimales pour générer un deuxième nombre de décimales,
- l'arrondissement de chacune de la pluralité de valeurs à virgule flottante d'origine (200) à une deuxième valeur à virgule flottante arrondie respective présentant le deuxième nombre de décimales, et
- la détermination de savoir si chaque deuxième valeur à virgule flottante arrondie se situe dans la limite d'erreur de sa valeur à virgule flottante d'origine respective ;
s'il est déterminé que chaque première valeur à virgule flottante arrondie se situe dans la limite d'erreur de sa valeur à virgule flottante d'origine respective,
- la délivrance en sortie (S430) de chaque première valeur à virgule flottante arrondie en tant que la pluralité de valeurs à virgule flottante arrondies (500) ; et
s'il est déterminé que chaque deuxième valeur à virgule flottante arrondie se situe dans la limite d'erreur de sa valeur à virgule flottante d'origine respective,
- la délivrance en sortie (S430) de chaque deuxième valeur à virgule flottante arrondie en tant que la pluralité de valeurs à virgule flottante arrondies (500).

7. Procédé selon la revendication 6, dans lequel le stockage comprend :
la conversion de chacune de la pluralité de valeurs à virgule flottante arrondies (500) à une valeur entière ; et
la réalisation d'une compression entière sur la pluralité de valeurs entières, et/ou
la réalisation d'une compression adaptative élément par élément sur la pluralité de valeurs à virgule flottante arrondies (500).

8. Procédé selon l'une quelconque des revendications 6 ou 7, comprenant en outre :
la modification des une ou plusieurs de la pluralité de valeurs à virgule flottante arrondies (500) sur la base d'une somme de la pluralité de valeurs à virgule flottante d'origine (200), où chacune des une ou plusieurs valeurs modifiées de la pluralité de valeurs à virgule flottante arrondies (500) se situe dans la limite d'erreur prédéfinie de sa valeur à virgule flottante d'origine respective, et/ou
la modification d'une valeur de la pluralité de valeurs à virgule flottante arrondies (500) de telle manière qu'une somme de la pluralité de valeurs à virgule flottante d'origine (200) est égale à une somme des une ou plusieurs valeurs modifiées de la pluralité de valeurs à virgule flottante arrondies (500), de la valeur modifiée de la pluralité de valeurs à virgule flottante arrondies (500) et de toute valeur non modifiée de la pluralité de valeurs à virgule flottante arrondies (500).

9. Procédé selon la revendication 8, dans lequel un nombre de bits de la valeur modifiée de la pluralité de valeurs à virgule flottante arrondies (500) est supérieur à un nombre de bits de chacune des une ou plusieurs valeurs modifiées de la pluralité de valeurs à virgule flottante arrondies (500) et de toute valeur non modifiée de la pluralité de valeurs à virgule flottante arrondies (500).
